# DEMANDE DE BREVET EUROPEEN

(11) **EP 0 652 598 A2**
(43) Date de publication de la demande: **10.05.1995**
(21) Numéro de dépôt: 94410093.2
(22) Date de dépôt: 25.10.1994
(51) Int. Cl.: H01L 29/747

(54) **Commutateur bidirectionnel à commande en tension**

(30) Priorité: 10.11.1993 FR 9313676
(71) Demandeur: SGS-THOMSON MICROELECTRONICS S.A., F-94250 Gentilly (FR)
(72) Inventeur: Pezzani, Robert, Parçay-Meslay, F-37210 Vouvray (FR)
(74) Mandataire: de Beaumont, Michel

(57) **Abrégé**

La présente invention concerne un ccmmutateur bidirectionnel monolithique de puissance à commande en tension ayant deux bornes principales (A1, A2) et commandé par une électrode de commande (g) dont la tension est référencée par rapport à l'une (A1) des bornes principales. Ce commutateur comprend un transistor MOS latéral à canal P (2, 8, 3) un transistor MOS vertical à canal N (3-4, 5, 6-1), le caisson de source (3) du transistor MOS à canal N vertical constituant aussi la source du transistor latéral ; un thyristor latéral (3, 8, 2, 24) dont les trois premières régions oorrespondent à la souroe, au drain et au canal du transistor MOS latéral ; un premier thyristor vertical (3, 1 20, 22) en parallèle sur le thyristor latéral ; et un deuxième thyristor vertical (21, 3, 1, 20) de polarité opposée au premier et en parallèle sur le transistor MOS vertical.

## Description

La présente invention concerne un composant semiconducteur destiné à constituer un commutateur bidirectionnel commandé. Plus particulièrement, la présente invention vise à prévoir un tel commutateur susceptible de commuter une puissance importante pour, par exemple, commuter directement une charge alimentée par le réseau électrique.

Le commutateur bidirectionnel connu le plus couramment utilisé pour commuter de façon contrôlée des puissances alternatives est le triac qui correspond à une association en antiparallèle de deux thyristors. Cependant, un triac nécessite comme un thyristor une commande en courant. Les courants de commande nécessaires pour assurer la commutation d'amorçage sont élevés, et même notablement plus élevés pour un triac que pour un thyristor. Les valeurs typiques observées se situent au voisinage de plusieurs dizaines de milliampères. Ces valeurs rendent souvent le triac incompatible avec une commande directe par un circuit logique de type MOS.

Par ailleurs, les composants de puissance connus présentant des commandes par des interfaces de type MOS, c'est-à-dire des commandes en tension, sont essentiellement les transistors MOS, IGBT, MCT ou équivalents. Ces deux derniers composants sont des associations de composants MOS assurant les commandes et de composants bipolaires (transistor bipolaire pour l'IGBT et thyristor pour le MCT) pour la partie de puissance.

Ces composants présentent les inconvénients suivants :
- ils sont unidirectionnels ce qui implique l'utilisation d'un pont redresseur pour de l'alternatif ;
- leur coût par ampère de courant toléré est élevé, notamment parce que la surfaoe occupée par les éléments de type MOS est importante devant la surface totale du composant.

Un objet de la présente invention est de prévoir un composant qui, comme un triac, permette de commuter directement des courants alternatifs provenant d'une source telle que le réseau électrique, et qui soit susceptible d'être commandé à l'amorçage par une tension, la borne de commande étant référencée à l'une donnée des bornes principales du composant.

Un autre objet de la présente invention est de prévoir un tel composant dont le coût par ampère de courant toléré soit faible, notamment du fait que la surface occupée par les composants de type MOS est réduite et que ces composants MOS sont de structure simple.

Pour atteindre cet objet, la présente invention prévoit un commutateur bidirectionnel monolithique à commande en tension ayant deux bornes principales et une électrode de commande dont la tension est référencée par rapport à l'une des bornes principales. Ce commutateur comprend un transistor MOS latéral à canal P et un transistor MOS vertical à canal N. Le caisson de source du transistor MOS à canal N vertical constitue aussi la source du transistor MOS à canal P, les types de conductivité N et P pouvant être inversés.

Selon un aspect de la présente invention, ce commutateur comprend, dans un substrat semiconducteur d'un premier type de conductivité, au moins un premier et au moins un deuxième caisson du deuxième type de conductivité ; une première région du premier type de conductivité formée dans chaque deuxième caisson et s'étendant le long d'une partie de la périphérie du deuxième caisson pour définir un premier canal ; une première borne principale reliée à une métallisation formée sur les deuxièmes caissons et les premières régions ; une deuxième borne principale reliée à une métallisation formée sur les premiers caissons ; et une borne de commande reliée à une première grille isolée formée au-dessus du premier canal et à une deuxième grille isolée formée au-dessus d'un deuxième canal correspondant à une portion de l'intervalle entre chacun des premiers et deuxièmes caissons.

La présente invention prévoit aussi un commutateur bidirectionnel monolithique de puissance à commande en tension ayant deux bornes principales et commandé par une électrode de commande dont la tension est référencée par rapport à l'une des bornes principales, comprenant un transistor MOS latéral à canal P ; un transistor MOS vertical à canal N, le caisson de source du transistor MOS à canal N vertical constituant aussi la source du transistor MOS à canal P ; un thyristor latéral dont les trois premières régions correspondent à la souroe, au drain et au canal du transistor MOS latéral ; un premier thyristor vertical en parallèle sur ledit thyristor latéral ; et un deuxième thyristor vertical de polarité opposée au premier et en parallèle sur le transistor MOS vertical.

Selon un aspect de la présente invention, ce commutateur de puissance comprend un substrat du premier type de conductivité ; au moins un premier et un deuxième caisson du deuxième type de conductivité formés dans la face supérieure du substrat ; au moins une première région de faible étendue et du premier type de conductivité formée dans chaque deuxième caisson et s'étendant le long d'une partie de la périphérie du deuxième caisson pour définir un premier canal ; une deuxième région du premier type de conductivité s'étendant dans chaque deuxième caisson et occupant sensiblement la moitié de la surface de ce deuxième caisson ; une couche du deuxième type de conductivité formée du côté de la face inférieure du substrat ; une troisième région du premier type de conductivité formée dans ladite couche sensiblement en regard des portions du ou des deuxièmes caissons de façon complémentaire des deuxièmes régions ; une diffusion profonde du deuxième type de conductivité reliant le deuxième caisson sur la face supérieure à ladite couche formée du côté de la face inférieure ; une quatrième région du premier type de conductivité formée dans le premier caisson ; une première métallisation reliant la première région au deuxième caisson ; une deuxième métallisation reliant la quatrième région à la diffusion profonde ; une première borne principale reliée à une troisième métallisation formée sur les deuxièmes caissons et les deuxièmes régions ; une deuxième borne principale reliée à une quatrième métallisation sur la face arrière ; et une borne de commande reliée à une première grille isolée formée au-dessus du premier canal et à une deuxième grille isolée formée au-dessus d'un deuxième canal correspondant à une portion de l'intervalle entre chacun des premiers et deuxièmes caissons.

Ces objets, caractéristiques et avantages ainsi que d'autres de la présente invention seront exposés en détail dans la description suivante de modes de réalisation particuliers faite, à titre illustratif, en relation avec les figures jointes parmi lesquelles :
la figure 1 représente un schéma bloc d'un composant que la présente invention vise à réaliser ;
les figures 2 et 3 illustrent des utilisations possibles du composant de la figure 1 ;
les figures 4A et 4B représentent un mode de réalisation d'un composant selon la présente invention dans deux configurations respectives de polarisation ;
la figure 4C représente un schéma équivalent du composant des figures 4A et 4B ;
les figures 5A et 5B représentent une association monolithique d'un composant selon la présente invention pouvant directement servir de commutateur de puissance, dans deux configurations de polarisation ; et
la figure 5C représente une variante d'une portion du composant des figures 5A et 5B.

On notera que, conformément à l'usage, les figures représentant des vues en coupe de composants semiconducteurs ne sont pas tracées à l'échelle, les dimensions transversales ou longitudinales des diverses couches étant arbitrairement réduites ou contractées pour simplifier la représentation.

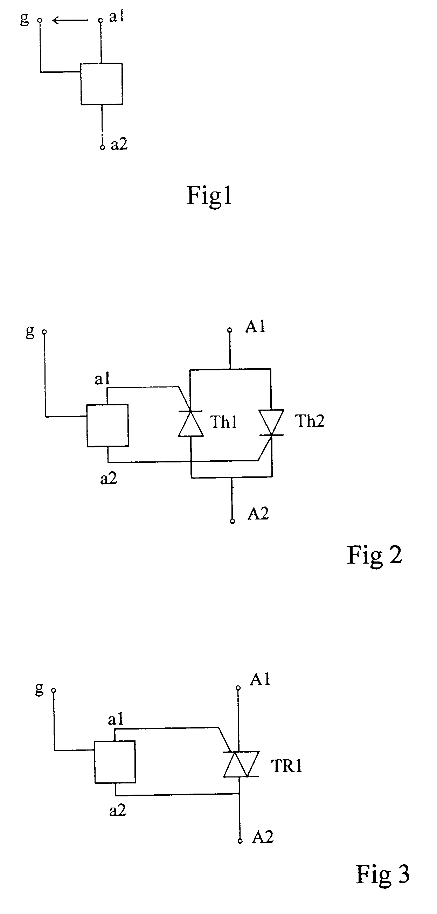

La figure 1 représente très schématiquement un composant que la présente invention vise à réaliser. Ce composant constitue un commutateur comprenant deux bornes principales a1 et a2 et une borne de commande g. Les bornes a1 et a2 sont destinées à être connectées à une source d'alimentation alternative par l'intermédiaire d'une charge. On considérera ci-après que la borne a1 constitue la borne de référence, par exemple au potentiel de la masse, et que le potentiel sur la borne a2 prend des valeurs alternativement positives et négatives par rapport au potentiel de référence sur la borne a1.

Dans le mode de réalisation décrit ci-après, le signal de mise en conduction appliqué sur la borne g doit être positif par rapport au potentiel de la borne a1 quand la borne a2 est positive par rapport à la borne a1, et doit être négatif par rapport au potentiel de la borne a1 quand la borne a2 est négative par rapport à la borne a1.

Comme on le verra également ci-après, il est prévu selon un premier aspect de la présente invention un composant tel que celui illustré en figure 1 susceptible de laisser passer seulement une faible puissance, c'est-à-dire un faible courant, entre les bornes a1 et a2. Un tel composant pourra être utilisé pour commuter des puissances importantes en association avec des thyristors ou un triac de la façon illustrée en figure 2 ou 3.

En figure 2, deux thyristors Th1 et Th2 sont disposés tête-bêche entre des bornes d'alimentation A1 et A2. Les gâchettes des thyristors sont respectivement connectées aux bornes a1 et a2 du composant selon l'invention. Dans ce cas, si la borne g du composant selon l'invention est polarisée positivement par rapport à la borne A1 tandis que cette borne est positive par rapport à la borne a2, le thyristor Th2 sera mis en conduction et, si la borne g est polarisée négativement par rapport à la borne A1 tandis que cette borne est négative par rapport à la borne A2, le thyristor Th1 sera mis en conduction.

La figure 3 représente un montage similaire dans lequel les thyristors Th1 et Th2 sont remplacés par un triac TR1 dont la gâchette est reliée à la borne a1 et dont la borne principale A2 opposée à celle correspondant à la gâchette est reliée à la borne a2.

D'autres applications du composant selon la présente invention apparaitront à l'homme de l'art. Dans les deux applications décrites précédemment, le composant selon l'invention doit être capable de supporter toute la tension appliquée aux bornes du composant principal de puissance, c'est-à-dire par exemple la tension du secteur mais par contre il doit laisser passer seulement un courant relativement faible : le courant de gâchette d'un thyristor ou d'un triac.

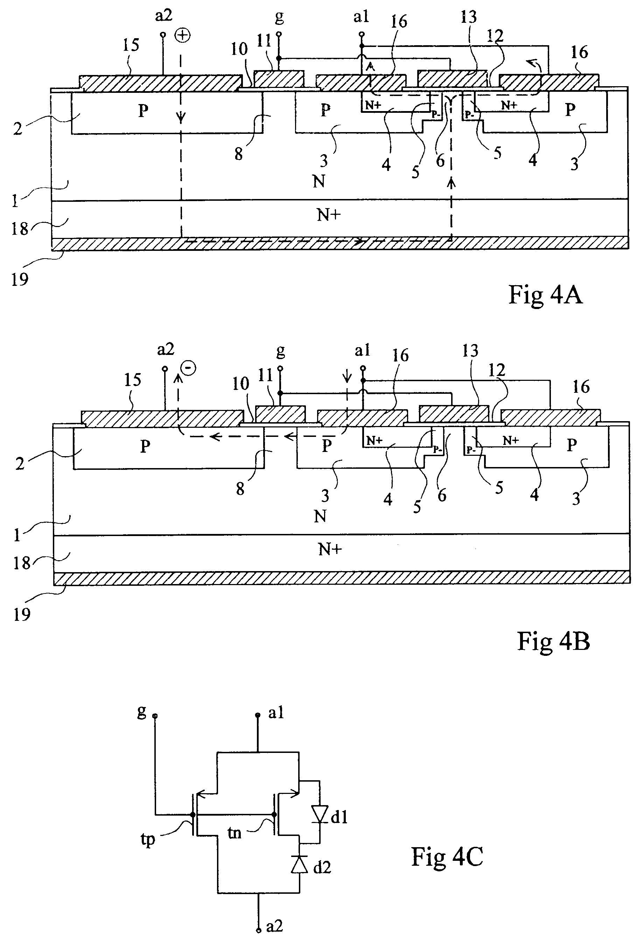

La figure 4A représente une vue en coupe simplifiée et schématique d'un mode de réalisation d'un composant selon l'invention. Ce composant est réalisé à partir d'un substrat semiconducteur 1 d'un premier type de conductivité. Dans la suite de la description, on considérera que le premier type de conductivité est le type N et le deuxième type de conductivité le type P mais bien entendu, ces types de conductivité peuvent être inversés, les polarisations étant alors inversées de façon correspondante. Dans la face supérieure du substrat sont formés un premier caisson 2 de type P et un deuxième caisson 3, également de type P. Dans le deuxième caisson 3 est formée une région 4 de type N fortement dopée (N⁺). Cette région 4 s'étend le long d'au moins un bord du caisson P pour définir avec la limite de ce caisson une région de canal 5. De préférence, la zone du caisson P qui correspond à la région de canal 5 est une zone de type P formée antérieurement et à plus faible niveau de dopage (P⁻). L'ensemble de régions 3, 4, 5 correspond à une cellule classique de transistor MOS de puissance vertical. De façon classique, en vue de dessus, la région 4, en forme de carré ou de cercle entoure la région 5 qui entoure une portion apparente 6 du substrat 1. En outre, le composant illustré en figure 4A peut être multicellulaire, c'est-à-dire qu'il comprendra, à l'intérieur du caisson 3 plusieurs régions annulaires 4 de type N⁺ et régions 5 associées. De même, un caisson P similaire au caisson 2 peut être disposé symétriquement à ce caisson 2 de l'autre côté du caisson 3.

Les caissons P 2 et 3 ont des limites en regard qui s'étendent parallèlement et de façon équidistante. La portion 8 du substrat de type N qui s'étend entre ces limites est recouverte d'une couche isolante mince 10 elle-même recouverte d'une grille conductrice 11. De même, la portion de canal 5 est revêtue d'une couche isolante mince 12, elle-même recouverte d'une grille conductrice 13. La surface supérieure du caisson 2 est revêtue d'une métallisation 15 et la surface supérieure du caisson 3 et de la région 4, en dehors de la région de canal 5, est revêtue d'une métallisation 16.

Les couches isolantes 10 et 12 sont classiquement réalisées en oxyde de silicium. Les couches conductrices 11, 13, 15, 16 peuvent être toutes constituées d'une métallisation bien que tout autre produit conducteur puisse être utilisé pour une ou plusieurs d'entre elles, par exemple du silicium polycristallin, un siliciure métallique, du silicium polycristallin revêtu de siliciure métallique, des alliages conducteurs, ou des empilements de couches conductrices.

De préférence, la face arrière du substrat 1 comprend une couche 18 du même type de conductivité que ce substrat mais fortement dopée (N⁺). Encore de préférence, la face arrière de la couche 18 est revêtue d'une métallisation flottante 19.

La métallisation 16 constitue la borne a1 du composant ; la métallisation 15 constitue la borne a2 du composant ; et les métallisations 11 et 13, reliées ensemble constituent la borne de grille g du composant.

Un schéma équivalent du composant de la figure 4A est illustré en figure 4C. Le composant comprend deux transistors MOS. Le premier transistor MOS est un transistor à canal N tn dont la source est constituée de la région N⁺ 4, dont la grille est constituée de la métallisation 13 et dont le drain correspond au substrat 1. Le deuxième transistor MOS est un transistor à canal P tp dont la grille correspond à la métallisation 11 et dont la source et le drain correspondent respectivement aux caissons 3 et 2. Ce transistor MOS à canal P est symétrique, c'est-à-dire qu'il peut bloquer une tension symétriquement dans les deux sens. La jonction entre le caisson 3 et le substrat 1 correspond à une diode d1 en anti-parallèle sur le transistor tn et la jonction entre le caisson 2 et le substrat 1 correspond à une diode d2, en série avec le transistor tn et dont l'anode est reliée à la borne a2. Ces jonctions peuvent supporter des hautes tensions étant donné la forte résistivité du substrat 1. De plus, le transistor MOS à canal P, sensible puisque le substrat est faiblement dopé, pourra avoir une épaisseur d'oxyde relativement épaisse pour favoriser la tenue en tension. Cette épaisseur sera par exemple de 1 à 2 micromètres et la longueur du canal pourra être de l'ordre de 200 à 300 micromètres. Par contre, le transistor MOS à canal N, ayant un canal 5 qui est inévitablement plus dopé que le substrat 1, devra pour être sensible avoir une épaisseur d'isolement de grille plus faible, par exemple de l'ordre de 0,1 à 0,3 micromètre et une longueur de canal également plus faible, par exemple de 5 à 50 micromètres. Toutefois, ces faibles dimensions sont sans inconvénient sur la tenue en tension qui est assurée par la disposition des cellules du transistor, comme cela est bien connu dans le domaine des transistors MOS verticaux.

On va maintenant expliquer le fonctionnement du composant selon l'invention quand une tension alternative est appliquée entre les bornes a1 et a2. Dans tous les cas, on considère que la borne a1 est à une tension de référence, par exemple la masse.

La figure 4A illustre le cas où la borne a2 est positive par rapport à la borne a1, par exemple à un potentiel de l'ordre de la centaine de volts. Alors, la jonction PN entre le caisson 2 et le substrat 1 (diode d2) est passante et la circulation de courant vers la borne a1 est bloquée par le transistor MOS à canal N (tn). Si une tension positive est appliquée sur la borne g, l'action de la grille 13 crée un canal dans la région 5 et le courant circule selon le trajet indiqué en tiretés de la borne a2, au substrat 1, à la couche 20, à la métallisation 21, à la couche 20, au substrat 1, dans la zone de canal 5 puis vers la région 4 et la borne a1. L'application de cette tension de commande positive sur la borne g contribue à augmenter l'état de blocage du transistor à canal P et aucun courant ne circule sous la grille 11 dans le canal 9.

La figure 4B illustre le cas où la borne a2 est négative par rapport à la borne a1. Alors, l'application d'une tension de commande négative sur la borne g rend passant le transistor MOS à canal P et le courant s'écoule de la borne a1 vers la borne a2 selon le trajet illustré en tiretés. L'application de cette tension négative sur la borne g contribue à renforcer le blocage du transistor à canal N.

Ainsi, le composant selon la présente invention constitue un dispositif à commande par une tension susceptible de recevoir entre ses bornes principales une tension alternative, la borne de commande g étant constamment référencée par rapport à la même borne principale (a1). On atteint donc bien l'objet principal de l'invention. Toutefois, dans ce composant, les trajets de courant incluent des passages dans des canaux de transistors MOS. En conséquence, sauf à prévoir des composants de très grande dimension, il est difficile d'atteindre des valeurs très faibles des résistances à l'état passant et le dispositif sera mal adapté à la commutation directe d'une charge de forte puissance sur un réseau électrique.

C'est pourquoi, on a prévu, comme cela a été exposé précédemment en relation avec les figures 2 et 3, d'utiliser le composant des figures 4A et 4B comme dispositif de commande d'un triac ou d'un assemblage de thyristors, le composant selon l'invention devant alors seulement être capable de bloquer ou de laisser passer des courants de gâchette de thyristors ou de triacs.

Selon un autre aspect de la présente invention, il est prévu d'intégrer un composant du type de celui de la figure 4 dans une structure monolithique où des thyristors prennent le relais des transistors MOS après mise en conduction. On obtient ainsi un composant susceptible de laisser passer de fortes puissances et donc de commuter directement la tension du réseau électrique sur une charge de forte puissance.

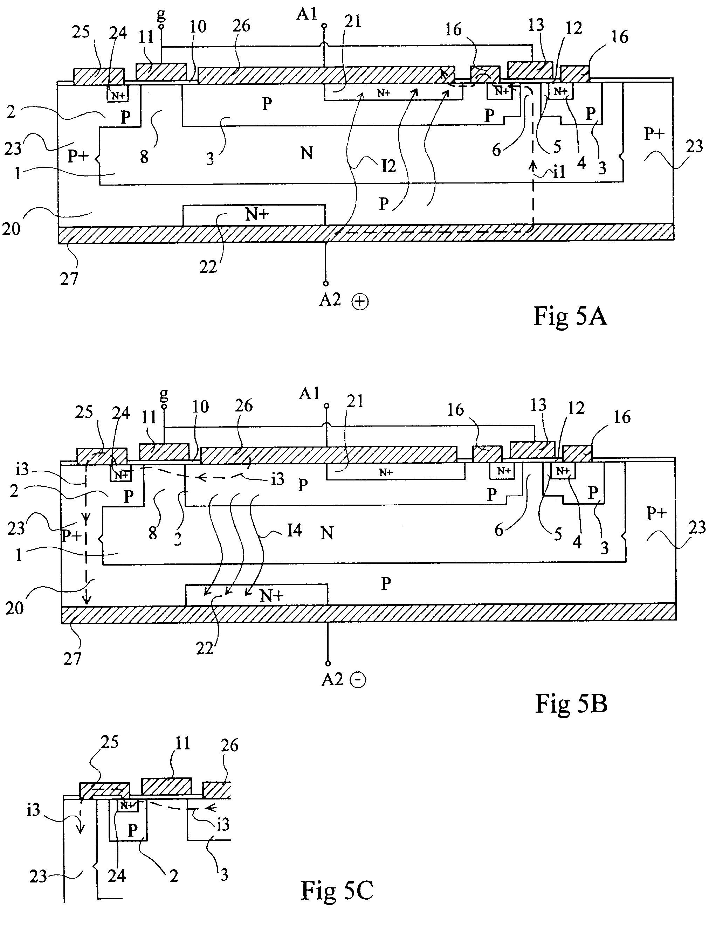

Un mode de réalisation de ce deuxième aspect de la présente invention est illustré en figure 5A. Dans cette figure, de mêmes références qu'en figure 4A désignent des éléments ayant les mêmes fonctions. Ainsi, on retrouve en figure 5A un substrat 1, un premier caisson 2 de type P, un deuxième caisson 3 de type P, une région 4 de type N⁺, une région de canal 8, une couche d'isolement de grille 10 et la couche de grille superposée 11 pour le transistor tp, une région de canal 5, une couche d'isolement de grille 12 et la couche de grille 13 correspondante pour le transistor tn. Une métallisation 16 relie la surface supérieure de la région 4 à une surface supérieure adjacente du caisson 3.

La face arrière du substrat 1, au lieu de comprendre une couche 18 de type N⁺, comprend une couche 20 de type P.

La structure de la figure 5A diffère aussi de celle de la figure 4A en ce que le caisson 3 (ou des caissons multiples correspondants) occupe la plus grande partie de la surface du composant. Ce caisson est divisé en deux parties, l'une où ce caisson s'étend jusqu'à la surface du composant et l'autre, de surface sensiblement égale, où une région 21 de type N⁺ est formée dans le caisson 3. Du côté de la face arrière du composant, dans la région 20, une région 22 de type N⁺ est sensiblement complémentaire en projection de la région 21 par rapport à la surface du caisson 3. En outre, une région 23 de diffusion profonde de type P relie le caisson 2 du côté de la face supérieure du composant à la région 20 du côté de la face inférieure du composant. Dans un mode de réalisation préféré illustré en figure 5A, la diffusion profonde 23 est disposée de façon périphérique et assure simultanément l'isolement du composant d'une façon analogue à ce qui est réalisé dans les thyristors de type à caisson. Enfin, une région 24 de type N⁺ est formée dans le caisson 2 de type P, légèrement en retrait par rapport à la région de canal 8. Cette région 24 est reliée par une métallisation 25 à la surface supérieure de la région de diffusion profonde 23.

Comme précédemment, les grilles 11 et 13 sont reliées à une borne g. Cette fois-ci, la métallisation 16, ainsi que la métallisation 25, est maintenue flottante et la face supérieure du caisson 3 ainsi que la face supérieure de la région 21 de type N⁺ sont recouvertes d'une couche conductrice 25 reliée à une borne A1. La métallisation de face arrière, 27, au lieu d'être maintenue flottante comme dans le cas de la figure 4A est reliée à une borne A2.

Le fonctionnement de ce dispositif va maintenant être expliqué dans les deux configurations possibles de polarisation de la borne A2 par rapport à la borne A1. Comme précédemment, on supposera que la borne A1 est à la masse et que la borne A2 peut être positive ou négative par rapport à cette borne A1. Si aucune tension n'est appliquée sur la borne g, c'est-à-dire que cette borne est maintenue flottante, si la borne A2 est positive par rapport à la borne A1, la jonction PN entre le caisson 3 et le substrat 1 bloque la tension inverse et si l'électrode A2 est négative par rapport à la borne A1, la jonction entre la couche 20 et le substrat 1 bloque la tension.

La figure 5A illustre le mode de mise en conduction du composant quand la borne A2 est positive par rapport à la borne A1. En ce cas, le composant étant initialement bloqué, l'application sur la borne de commande g d'une tension positive par rapport à la borne A1, crée un canal dans la région 5. Alors un courant i₁ circule de la borne A2 de la métallisation 27, à travers la région P 20, le substrat 1, la région 6 de ce substrat, le canal 5, la région 4, la métallisation 16, une portion du caisson 3, et la région 21 vers la borne A1. Le courant circulant de la métallisation 16 vers la région N⁺ 21 se comporte comme un courant de gâchette pour le thyristor PNPN comprenant les couches 20, 1, 3 et 21 et ce thyristor s'amorce et entraîne la circulation d'un courant I₂ avec une très faible chute de tension à ses bornes. De façon classique, la région 21 (comme la région 22) peut comprendre des courts-circuits d'émetteur, c'est-à-dire que cette région est interrompue de sorte que des portions du caisson 3 affleurent en surface dans lesdites interruptions. Ce thyristor se bloque quand la tension à ses bornes s'inverse (ou plus exactement dès que le courant I₂ qui le traverse devient inférieur à son courant de maintien IH).

La figure 5B illustre le cas où la borne A2 est négative par rapport à la borne A1. Pour provoquer la mise en conduction, on polarise la grille g négativement par rapport à l'électrode A1. Il se forme alors un canal dans la région 9 du substrat N sous-jacente à la grille 11 et le transistor correspondant au transistor MOS à canal P tp de la figure 4C devient conducteur. Un courant i₃ circule de la borne A1 dans le caisson 3, le canal 9, une portion du caisson 2, la région 24, la métallisation 25, la diffusion profonde 23 vers la couche 20 et la borne A2. Ce courant i₃ correspond à la mise en conduction d'un thyristor latéral PNPN constitué des régions 3, 8, 2, 24, qui entraine la mise en conduction d'un thyristor vertical principal comprenant les régions 3, 1, 20 et 22 et un courant I₄ circule entre les bornes A2 et A1. Ce thyristor se bloque quand la tension à ses bornes s'inverse (dès que le courant I₂ qui le traverse devient inférieur à son courant de maintien IH).

La figure 5C illustre une variante de réalisation de la partie supérieure gauche du composant de la figure 5A. Dans cette variante, le caisson 2 est disjoint de la diffusion profonde 23 tandis que la métallisation 25 relie toujours la face supérieure des régions 23 et 24.

Bien entendu, la présente invention est susceptible de nombreuses variantes et modifications qui apparaîtront à l'homme de l'art spécialisé dans la fabrication des thyristors et triacs. En particulier, les niveaux de dopage et les dimensions des diverses couches n'ont pas été indiqués car, pour le mode de réalisation des figures 4A et 4B, ils correspondent à ce qui est classiquement utilisé dans le domaine de la réalisation des transistors MOS verticaux et, en ce qui concerne les figures 5A et 5B, ils correspondent à ce qui est classiquement utilisé dans le domaine des thyristors et triacs. Toutes les variantes habituellement utilisées pour ces divers composants pourront également être adjointes au dispositif selon l'invention.

## Revendications

1. Commutateur bidirectionnel monolithique à commande en tension ayant deux bornes principales (a1, a2) et commandé par une électrode de commande (g) dont la tension est référencée par rapport à l'une (a1) des bornes principales, caractérisé en ce qu'il comprend dans la surface supérieure d'un substrat semiconducteur de type N un transistor MOS latéral à canal P (2, 8, 3) et un transistor MOS vertical à canal N (3-4, 5, 6-1), le caisson de source (3) du transistor MOS vertical à canal N constituant aussi la source du transistor MOS latéral à canal P, une première borne principale reliée auxdites sources communes, une deuxième borne principale reliée au drain du transistor MOS latéral à canal P et une borne de commande connectée aux grilles desdits transistors MOS.

2. Commutateur bidirectionnel selon la revendication 1, caractérisé en ce que les types de conductivité N et P sont inversés.

3. Commutateur bidirectionnel monolithique à commande en tension ayant deux bornes principales (a1, a2) et une électrode de commande (g) dont la tension est référencée par rapport à l'une (a1) des bornes principales, caractérisé en ce qu'il comprend, dans un substrat semiconducteur (1) d'un premier type de conductivité :
au moins un premier (2) et au moins un deuxième (3) caisson du deuxième type de conductivité ;
une première région (4) du premier type de conductivité formée dans chaque deuxième caisson et s'étendant le long d'une partie de la périphérie du deuxième caisson pour définir un premier canal (5) ;
une première borne principale (a1) reliée à une métallisation (16) formée sur les deuxièmes caissons et les premières régions ;
une deuxième borne principale (a2) reliée à une métallisation (15) formée sur les premiers caissons ; et
une borne de commande (g) reliée à une première grille isolée (13) formée au-dessus du premier canal (5) et à une deuxième grille isolée (11) formée au-dessus d'un deuxième canal (8) correspondant à une portion de l'intervalle entre chacun des premiers et deuxièmes caissons.

4. Commutateur bidirectionnel selon la revendication 1, caractérisé en ce que sa face arrière comprend une région (18) du premier type de conductivité à haut niveau de dopage dont la face extérieure est revêtue d'une métallisation (19).

5. Application du commutateur bidirectionnel selon l'une quelconque des revendications 1 à 4, en tant que composant de commande de gâchette d'un triac ou d'un assemblage de thyristors.

6. Commutateur bidirectionnel monolithique de puissance à commande en tension ayant deux bornes principales (A1, A2) et commandé par une électrode de commande (g) dont la tension est référencée par rapport à l'une (A1) des bornes principales, caractérisé en ce qu'il comprend :
un transistor MOS latéral à canal P (2, 8, 3) ;
un transistor MOS vertical à canal N (3-4, 5, 6-1), le caisson de source (3) du transistor MOS à canal N vertical constituant aussi la source du transistor MOS à canal P ;
un thyristor latéral (3, 8, 2, 24) dont les trois premières régions correspondent à la source, au drain et au canal dudit transistor MOS latéral ;
un premier thyristor vertical (3, 1, 20, 22) en parallèle sur ledit thyristor latéral ; et
un deuxième thyristor vertical (21, 3, 1, 20) de polarité opposée au premier et en parallèle sur ledit transistor MOS vertical.

7. Commutateur bidirectionnel monolithique de puissance à commande en tension selon la revendication 6, ayant deux bornes principales (A1, A2) et une électrode de commande (g) dont la tension est référencée par rapport à l'une (A1) des bornes principales, caractérisé en ce qu'il comprend :
un substrat (1) du premier type de conductivité ;
au moins un premier (2) et un deuxième (3) caisson du deuxième type de conductivité formés dans la face supérieure du substrat ;
au moins une première région (4) de faible étendue et du premier type de conductivité formée dans chaque deuxième caisson et s'étendant le long d'une partie de la périphérie du deuxième caisson pour définir un premier canal (5) ;
une deuxième région (21) du premier type de conductivité s'étendant dans chaque deuxième caisson (3) et occupant sensiblement la moitié de la surface de ce deuxième caisson ;
une couche (20) du deuxième type de conductivité formée du côté de la face inférieure du substrat ;
une troisième région (22) du premier type de conductivité formée dans ladite couche (20) sensiblement en regard des portions du ou des deuxièmes caissons de façon complémentaire des deuxièmes regions ;
une diffusion profonde (23) du deuxième type de conductivité reliant le deuxième caisson (2) sur la face supérieure à ladite couche (20) formée du côté de la face inférieure ;
une quatrième région (24) du premier type de conductivité formée dans le premier caisson (2) ;
une première métallisation (16) reliant la première région (4) au deuxième caisson ;
une deuxième métallisation (25) reliant la quatrième région (24) à la diffusion profonde ;
une première borne principale (A1) reliée à une troisième métallisation (26) formée sur les deuxièmes caissons (3) et les deuxièmes régions (21) ;
une deuxième borne principale (A2) reliée à une quatrième métallisation (27) sur la face arrière ; et
une borne de commande (g) reliée à une première grille isolée (13) formée au-dessus du premier canal (5) et à une deuxième grille isolée (11) formée au-dessus d'un deuxième canal (8) correspondant à une portion de l'intervalle entre chacun des premiers et deuxièmes caissons.

8. Commutateur bidirectionnel de puissance selon la revendication 7, caractérisé en ce que ladite diffusion profonde (23) est formée à la périphérie du composant.

9. Commutateur bidirectionnel selon l'une quelconque des revendications 3 à 8, caractérisé en ce que la région (5) correspondant au premier canal est plus faiblement dopée que le reste du deuxième caisson (3).

10. Commutateur bidirectionnel selon l'une quelconque des revendications 7 à 9, caractérisé en ce que le deuxième caisson (2) est contigu à la diffusion profonde (23).
